# EUROPÄISCHE PATENTSCHRIFT

(11) **EP 3 497 762 B1**
(45) Veröffentlichungstag und Bekanntmachung des Hinweises auf die Patenterteilung: **01.04.2020**
(21) Anmeldenummer: 17808757.3
(22) Anmeldetag: 16.11.2017
(51) Int. Cl.: H05K 5/02, H02B 3/00, H02B 15/02, H02B 1/30, H02B 1/38

(54) **SCHALTSCHRANKANORDNUNG SOWIE EIN ENTSPRECHENDES BETRIEBSVERFAHREN**
ELECTRICAL CABINET ARRANGEMENT AND CORRESPONDING OPERATING PROCEDURE
ENSEMBLE ARMOIRE ÉLECTRIQUE ET PROCÉDÉ D'EXPLOITATION CORRESPONDANT

(30) Priorität: 17.11.2016 DE 102016122157
(43) Veröffentlichungstag der Anmeldung: 19.06.2019
(73) Patentinhaber: Rittal GmbH & Co. KG, 35745 Herborn (DE)
(72) Erfinder: HAIN, Markus, 35684 Dillenburg (DE); HOLIGHAUS, Heiko, 35713 Eschenburg (DE); BOEHME, Siegfried, 06766 Wolfen (DE)
(74) Vertreter: Angerhausen, Christoph
(86) Internationale Anmeldenummer: PCT/DE2017/100982
(87) Internationale Veröffentlichungsnummer: WO 2018/091041

(56) Entgegenhaltungen:
- EP-A1- 2 928 033
- EP-A2- 1 801 942
- WO-A1-2010/054143
- DE-B3-102014 103 230

## Beschreibung

Die Erfindung geht aus von einer Schaltschrankanordnung, die mindestens ein Schaltschrankgehäuse mit einer elektrischen Schaltanlage aufweist.

Die DE 10 2006 011 127 B4 beschreibt eine Schaltschrankanordnung mit zumindest einem Schaltschrank und einer Schaltschranküberwachungseinrichtung, die zur Überwachung schaltschrankspezifischer Zustandsgrößen einschließlich Temperatur, Feuchte, Zugang, Vibration, Rauch, Strom und/oder Spannung ausgebildet ist und in mindestens einem Schaltschrank angeordnete zentrale Überwachungs- und Steuerungskomponenten aufweist, welche mit die Zustandsgrößen überwachenden Sensoren und ansteuerbaren Aktoren und/oder Meldeeinheiten in Datenübertragungsverbindung gebracht oder bringbar sind. Zumindest eine zentrale Überwachungs- und Steuerungskomponente ist als Basisstation mit einer drahtlosen Sende-/Empfangsschnittstelle ausgebildet. Weiterhin ist zumindest ein Teil der Sensoren mit einer drahtlosen Sende- und/oder Empfangsschnittstelle zur drahtlosen Datenübertragung zwischen den Sensoren und der Basisstation ausgestattet. Die Basisstation und die Sensoren sind mit einer Identifikationskennzeichnung versehen, die in einem Speicher der Basisstation und des betreffenden Sensors hinterlegt ist. Des weiteren ist vorgesehen, dass zwischengeordnete Sensoren zum Abgeben einer Meldung an die Basisstation in bestimmten Zeitabständen ausgebildet sind, wobei die Basisstation zur Funktionsüberwachung ausgewertet wird.

Die DE 101 19 637 A1 beschreibt ein Schaltschrank-Überwachungssystem, das zum Überwachen von den Schaltschrank selbst betreffenden Funktionen ausgebildet ist und eine zentrale Überwachungseinheit sowie mindestens eine damit über eine Datenübertragungsstrecke in Datenübertragungsverbindung stehende oder bringbare, einer jeweiligen Funktion oder Funktionsgruppe gleichartiger Funktionen zugeordnete dezentrale Einheit aufweist. Für eine Schaltschrank-Überwachungseinrichtung wird die zentrale Überwachungseinheit als Haupteinheit mit zumindest einer standardisierten Schnittstelle für eine drahtlose Datenübertragung versehen. Die Datenübertragungsstrecke umfasst zumindest eine drahtlose Übertragungsstrecke, wobei die mindestens eine dezentrale Einheit ebenfalls mit zumindest einer an die Schnittstelle der Haupteinheit angepassten standardisierten weiteren Schnittstelle für die drahtlose Übertragung versehen ist.

Aus der DE 100 65 898 C2 ist eine elektrisch betätigbare Verriegelungseinrichtung für eine Tür eines Schaltschrankes bekannt, die eine elektromechanische Betätigungseinheit, mindestens einen an einem Schrankrahmen angebrachten ersten Verriegelungsteil und mindestens einen mit diesem zusammenwirkenden, an der Tür angebrachten zweiten Verriegelungsteil aufweist, wobei eines der beiden Verriegelungsteile mit einem begrenzt bewegbaren Riegel versehen ist, der mit einem Verriegelungselement des anderen Verriegelungsteils zum Verriegeln oder Öffnen der Tür in oder außer Eingriff bringbar ist.

Die EP 1 801 942 A2 offenbart eine Schaltschrankanordnung mit den Merkmalen des Oberbegriffs des Anspruchs 1. Weitere Schaltschrankanordnungen mit einem Schaltschrankgehäuse mit einer elektrischen Schaltanlage und mit einer Mensch-Maschine-Schnittstelle und einer optischen Anzeige, über die ein Schaltplan der elektrischen Schaltanlage angezeigt ist, sind durch die DE 10 2014 103230 B3, EP 2 928 033 A1, WO 2010/054143 A1 und WO 2008/129179 A2 bekannt.

Die in den Schaltschrankgehäusen der Schaltschrankanordnung aufgenommenen elektrischen Schaltanlagen sind häufig hoch komplex aufgebaut, wobei sich die Verschaltung der einzelnen Komponenten der elektrischen Schaltanlage mitunter auch über die Lebensdauer der elektrischen Schaltanlage verändert, beispielsweise indem im Nachgang zur Ersterrichtung der elektrischen Schaltanlage Ergänzungen oder Abänderungen der elektrischen Schaltanlage vorgenommen werden. Dies hat zur Folge, dass für einen an der elektrischen Schaltanlage arbeitenden Techniker häufig bei nur unzureichender Dokumentation des Aufbaus der elektrischen Schaltanlage sowie der vorgenommenen Änderungen die von ihm vorgefundene elektrische Verschaltung der Komponenten der elektrischen Schaltanlage nicht ohne weiteres nachvollziehbar ist.

Es ist daher die Aufgabe der Erfindung, eine Schaltschrankanordnung der eingangs beschriebenen Art derartig weiter zu entwickeln, dass sie eine hohe Servicefreundlichkeit aufweist.

Diese Aufgabe wird durch eine Schaltschrankanordnung mit den Merkmalen des Anspruchs 1 gelöst. Der nebengeordnete Anspruch 10 betrifft ein entsprechendes Betriebsverfahren für eine derartige Schaltschrankanordnung. Die abhängigen Ansprüche betreffen jeweils vorteilhafte Ausführungsformen der Erfindung.

Demgemäß ist vorgesehen, dass die Schaltschrankanordnung neben dem mindestens einen Schaltschrankgehäuse mit der elektrischen Schaltanlage weiterhin eine Mensch-Maschine-Schnittstelle mit einer optischen Anzeige aufweist, über die ein Schaltplan der elektrischen Schaltanlage angezeigt ist, wobei mindestens eine Komponente der elektrischen Schaltanlage eine maschinenlesbare Kennung aufweist, über die die Komponente einem diese kennzeichnenden Komponentensymbol in dem Schaltplan eindeutig zugeordnet ist. Eine Datenschnittstelle ist zwischen der Mensch-Maschine-Schnittstelle und der elektrischen Schaltanlage ausgebildet. Ein Zustand der Komponente ist anhand eines optischen Zustands des Komponentensymbols über die optische Anzeige angezeigt.

Vorzugsweise weisen zumindest sämtliche für die Funktion der elektrischen Schaltanlage relevanten aktiven und passiven Komponenten, insbesondere solche, die einer Wartung bedürfen können oder Verschleiß unterliegen, eine sie eindeutig kennzeichnende maschinenlesbare Kennung auf. Grundsätzlich ist die Verwendung der maschinenlesbaren Kennung jedoch auf keine bestimmten Komponenten der elektrischen Schaltanlage begrenzt. Weiterhin können die mit der maschinenlesbaren Kennung versehenen Komponenten, insbesondere die aktiven Komponenten, mindestens einen Sensor aufweisen, über den ein Zustand der betreffenden Komponente ermittelt wird. Ein solcher Zustand kann beispielsweise eine Temperatur, eine Verlustleistung, eine Stromaufnahme oder ein beliebiger anderer technischer Messwert sein. Die von den verschiedenen Sensoren der verschiedenen Komponenten erfassten Messwerte können von einem aus dem Stand der Technik bekannten CMC-System erfasst, gesammelt und gegebenenfalls gespeichert und/oder ausgewertet werden.

Die Mensch-Maschine-Schnittstelle kann daher beispielsweise eine Funkschnittstelle zu einem CMC-Modul der Schaltschrankanordnung aufweisen. Es kann jedoch auch vorgesehen sein, dass das CMC-Modul über einen Prozessor ausgelesen wird, der wiederum über eine Schnittstelle, beispielsweise eine Funkschnittstelle, mit der Mensch-Maschine-Schnittstelle kommunikativ für den Austausch der erfassten Messdaten oder davon abgeleiteter Daten in Verbindung steht. Der Prozessor kann beispielsweise auch Bestandteil der Mensch-Maschine-Schnittstelle sein. Stattdessen können die einzelnen Sensoren der Komponenten auch jeweils eigene Schnittstellen, beispielsweise Funkschnittstellen aufweisen, über die sie unmittelbar mit der Mensch-Maschine-Schnittstelle in Verbindung stehen.

Der Schaltplan kann in einem Speicher hinterlegt sein, welcher entweder dem die jeweils betreffende elektrische Schaltanlage umfassenden Schaltschrankgehäuse zugeordnet, oder in einem dezentralen Speichersystem hinterlegt ist. Beispielsweise kann der Speicher an einer Schaltplantasche an der Innenseite der Tür des die Schaltanlage aufweisenden Schaltschrankgehäuses angeordnet oder ein von der Außenseite des Schaltschrankgehäuses auslesbarer Speicher sein. Dazu kann der Speicher beispielsweise in das Türschloss integriert sein. Dabei kann der Speicher etwa ein Speicher in dem Türschloss des betreffenden Schaltschrankgehäuses sein, der Bestandteil eines Zugangskontrollsystems des Türschlosses ist, wonach eine Betätigung des Türschlosses nur nach erfolgreicher Autorisierung möglich ist. Das Zugangskontrollsystem kann hierbei weiterhin dazu eingerichtet sein, einen Zugriff auf den Speicher ebenfalls nur nach erfolgreicher Autorisierung zu erlauben.

Die Mensch-Maschine-Schnittstelle kann beispielsweise eine Vorrichtung zum berührungslosen Auslesen der maschinenlesbaren Kennung des jeweils die elektrische Schaltanlage betreffenden Schaltplans sein oder eine solche Vorrichtung aufweisen. Ein Benutzer kann somit mittels der Mensch-Maschine-Schnittstelle die maschinenlesbare Kennung einer bestimmten Komponente der elektrischen Schaltanlage einlesen und die Anordnung der betreffenden Komponente in dem Schaltplan über die optische Anzeige anzeigen lassen. Dazu kann das die betreffende elektrische Komponente kennzeichnende Komponentensymbol in dem angezeigten Schaltplan optisch hervorgehoben oder anderweitig optisch kenntlich gemacht werden, so dass für den Benutzer unmittelbar die elektrische Verschaltung der betreffenden Komponente ersichtlich wird sowie gegebenenfalls andere technische Werte, etwa die Komponente betreffende Messwerte, die dem Symbol beigeordnet oder anderweitig zugeordnet über die optische Anzeige ausgegeben werden.

Bedarfsweise kann mit der optisch hervorgehobenen Anzeige des kennzeichnenden Komponentensymbols mindestens ein aktueller oder ein historischer Messwert, welche die zugehörige Komponente betrifft, über die optische Anzeige angezeigt werden. Des Weiteren kann, falls vorhanden, eine Dokumentation vorgenommener Änderungen an der elektrischen Schaltanlage, welche die ausgewertete Komponente betreffen, über die optische Anzeige angezeigt werden.

Die Mensch-Maschine-Schnittstelle kann eine bidirektionale Schnittstelle sein, über die mindestens ein Istwert des Zustands der Komponente, beispielsweise ein sensorisch erfasster Messwert, an die Mensch-Maschine-Schnittstelle weitergeleitet und gegebenenfalls über die optische Anzeige angezeigt werden, und/oder ein über eine Eingabe der Mensch-Maschine-Schnittstelle erfasster Sollwert des Zustands der Komponente an die Komponente oder eine die Komponente ansteuernde Steuereinheit im Innern weitergeleitet werden.

Für den Fall, dass über die Eingabe der Mensch-Maschine-Schnittstelle eine Änderung der elektrischen Schaltanlage vorgenommen worden ist, beispielsweise dass eine Änderung eines Sollwertes des Zustands einer der Komponenten der elektrischen Schaltanlage erfolgt ist, so kann diese Änderung in dem Schaltplan durch eine entsprechende Änderung des Schaltplans hinterlegt werden, so dass die Änderung bzw. ein aktualisierter Schaltplan beispielsweise für zukünftige Wartungsmaßnahmen an der elektrischen Schaltanlage nachvollziehbar zur Verfügung steht.

Der optische Zustand des Komponentensymbols kann über die Mensch-Maschine-Schnittstelle manipulierbar sein, wobei entsprechend einer erfolgten Manipulation des Zustands des Komponentensymbols ein Zustandsänderungssignal erzeugt und an die Komponente oder eine die Komponente ansteuernde Steuereinheit weitergeleitet ist. Der Zustand des Komponentensymbols ist auf keine bestimmten Zustände beschränkt. So kann beispielsweise vorgesehen sein, dass das Komponentensymbol ein gängiges elektronisches Schaltzeichen ist, dem ein Messwert beigeordnet ist, beispielsweise eine aktuelle Stromaufnahme der betreffenden elektronischen Komponente. Die Manipulation des betreffenden kennzeichnenden Komponentensymbols kann daher in der Variation des dem Komponentensymbol beigeordneten Messwertes sein, so dass durch die Variation des gemessenen Istwertes der Messgröße ein Sollwert für die gemessene Größe und dementsprechend ein Steuerbefehl an die elektrische Schaltanlage weitergeleitet wird, welcher zu der Anpassung des gemessenen Istwertes an den manipulierten Sollwert führt.

Die elektrische Schaltanlage kann insbesondere im Innern des mindestens einen Schaltschrankgehäuses aufgenommen sein, wobei eine Sensoranordnung mit mindestens einem Sensor dazu eingerichtet ist, mindestens einen Messwert der mindestens einen elektronischen Komponente der elektrischen Schaltanlage zu erfassen, wobei der Messwert oder eine davon abgeleitete optische Ausgabe auf der optischen Anzeige örtlich dem die Komponente kennzeichnenden Komponentensymbol zugeordnet ausgegeben ist.

Wenn die elektrische Schaltanlage mindestens eine Komponente mit einer diese Komponente eindeutig identifizierenden maschinenlesbaren Kennung aufweist, kann die Mensch-Maschine-Schnittstelle dazu eingerichtet sein, nach erfolgtem Auslesen der Kennung und Identifizieren der von der Kennung gekennzeichneten Komponente, das die Komponente repräsentierende Komponentensymbol in dem optisch angezeigten Schaltplan optisch hervorzuheben und/oder mindestens einen die Komponente betreffenden Mess- oder Kennwert über die optische Anzeige auszugeben. Das Identifizieren der von der Kennung gekennzeichneten Komponente kann beispielsweise durch Abgleichen der Kennung mit einem Datensatz erfolgen, welcher den Schaltplan enthält, einschließlich einer eindeutigen Zuordnung sämtlicher Kennungen zu den zugehörigen repräsentierenden Komponentensymbolen in dem Schalplan.

Die Komponente kann beispielsweise ein Türschloss des Schaltschrankgehäuses sein, das ein Betätigungsglied zur Verstellung des Türschlosses zwischen einer Offenposition und einer Schließposition aufweist, wobei das Türschloss einen elektronisch ansteuerbaren Schlossriegel aufweist, der in seinem ersten Zustand eine Verriegelungsposition einnimmt, in der er das Betätigungsglied in der Schließposition verriegelt, und der in seinem zweiten Zustand eine Freigabeposition einnimmt, in der er das Betätigungsglied freigibt. Wenn die Schaltschrankanordnung dazu eingerichtet ist, dass eine Betätigung des Schlossriegels lediglich über die Mensch-Maschine-Schnittstelle erlaubt ist, so ist eine Zugangskontrolle zu dem betreffenden Schaltschrankgehäuse derart möglich, dass die Authentifizierung des für den Zugriff auf das Schaltschrankgehäuse erlaubten Personenkreises auf die Mensch-Maschine-Schnittstelle verlagert wird, beispielsweise indem der Zugriff auf die Mensch-Maschine-Schnittstelle nur nach einem erfolgreichen Login erfolgen kann.

Die Komponente kann weiterhin beispielsweise eine Power Distribution Unit (PDU) sein, über die mindestens eine weitere elektrische Komponente der elektrischen Schaltanlage mit elektrischer Energie versorgt ist, und mit der der mindestens eine die weitere Komponente betreffende Zustand, insbesondere eine Messgröße, erfasst und über die Datenschnittstelle an die Mensch-Maschine-Schnittstelle weitergeleitet ist.

Die Schaltschrankanordnung kann eine Überwachungseinrichtung aufweisen, die dazu eingerichtet ist, den jeweiligen Zustand einer Mehrzahl der Komponenten der elektrischen Schaltanlage zu überwachen und, wenn eine Zustandsänderung mindestens einer der Komponenten erfasst ist, den optischen Zustand des jeweiligen kennzeichnenden Komponentensymbols in dem Schaltplan zu aktualisieren, so dass ein aktualisierter Schaltplan erzeugt ist.

Die Schaltschrankanordnung kann weiterhin einen Prozessor mit Schreib-Lese-Zugriff auf einen nichtflüchtigen Speicher aufweisen, wobei der Speicher in oder an dem mindestens einen Schaltschrankgehäuse mit der elektrischen Schaltanlage, insbesondere an einer an der Innenseite einer Tür des Schaltschrankgehäuses befestigten Schaltplantasche angeordnet ist, wobei der Prozessor dazu eingerichtet ist, den aktualisierten Schaltplan in den nichtflüchtigen Schreib-Lese-Speicher zu schreiben.

Erfindungsgemäss ist die Mensch-Maschine-Schnittstelle dazu eingerichtet, eine Änderung der elektrischen Schaltanlage, insbesondere die Hinzufügung oder Entfernung einer elektrischen Komponente zu erfassen und diese Änderung entsprechend in dem Schaltplan zu hinterlegen. Dazu weist die Mensch-Maschine-Schnittstelle eine optische Erfassungseinrichtung auf, etwa ein Photomodul, die eine Komponentenerkennung aufweist. Die Komponentenerkennung ist dabei dazu eingerichtet sein, die maschinenlesbare Kennung der Komponenten der elektrischen Schaltanlage zu erfassen und durch Abgleich mit dem Schaltplan eine Veränderung der Komponentenbestückung zu erfassen.

Gemäß einem anderen Aspekt betrifft die Erfindung ein Betriebsverfahren für eine Schaltschrankanordnung der zuvor beschriebenen Art, wobei das Betriebsverfahren die Schritte aufweist:
- Auswählen einer bestimmten elektrischen Komponente aus einer Mehrzahl elektrischer Komponenten der elektrischen Schaltanlage der Schaltschrankanordnung durch Einlesen der Kennung der bestimmten Komponente; und
- Anzeigen des Schaltplans auf einer optischen Anzeige der Mensch-Maschine-Schnittstelle, wobei ein Zustand der Komponente anhand eines optischen Zustands des die bestimmte Komponente kennzeichnenden Komponentensymbols über die optische Anzeige angezeigt wird.
- Erfassen einer Änderung der elektrischen Schaltanlage mit einer Komponentenerkennung einer optischen Erfassungseinrichtung der Mensch-Maschine-Schnittstelle, insbesondere die Hinzufügung oder Entfernung einer elektrischen Komponente, und
- Übernehmen dieser Änderung in den Schaltplan, wobei die Komponentenerkennung die maschinenlesbare Kennung der Komponenten der elektrischenn Schaltanlage erfasst und durch Abgleichen mit dem Schaltplan eine Veränderung einer Komponentenbestückung der elektrischen Schaltanlage erfasst.

Das Anzeigen kann das Abrufen des Zustands der bestimmten Komponente unmittelbar von der bestimmten Komponente oder von einer Überwachungseinrichtung umfassen, in der aktuelle und/oder historische Zustandsdaten zumindest betreffend die bestimmte Komponente vorgehalten sind. Die bestimmte Komponente kann dazu sich selbst überwachend mit entsprechenden Sensoren und einem Speicher zur Hinterlegung von Zustandsdaten sein. Alternativ können gesonderte, die betreffende Komponente überwachende Sensoren mit einem entsprechenden Auswertesystem, beispielsweise einem CMC-System, vorgesehen sein.

Für eine Änderung des Zustands der bestimmten Komponente können Zustandsänderungsdaten oder Zustandsänderungsbefehle über die Mensch-Maschine-Schnittstelle eingegeben und über die Datenschnittstelle an die bestimmte Komponente unmittelbar oder mittelbar über eine diese ansteuernde Steuereinheit, die Teil der elektrischen Schaltanlage ist, weitergeleitet werden.

Die bestimmte Komponente kann ein Türschloss mit einem elektronisch ansteuerbaren Schlossriegel sein, der in seinem ersten Zustand eine Verriegelungsposition einnimmt, in der er ein Betätigungsglied verriegelt, und der in seinem zweiten Zustand eine Freigabeposition einnimmt, in der er das Betätigungsglied freigibt, wobei das Verfahren weiterhin das Eingeben eines Freigabebefehls oder eines Verriegelungsbefehls über die Mensch-Maschine-Schnittstelle aufweist, woraufhin der Schlossriegel entsprechend dem Befehl in die Freigabeposition oder die Verriegelungsposition überführt wird.

Das Verfahren kann weiterhin das Ändern des Zustands der bestimmten Komponente und das Hinterlegen des geänderten Zustands durch Ändern des optischen Zustands des kennzeichnenden Komponentensymbols in dem Schaltplan aufweisen.

Das Betriebsverfahren kann weiterhin das kontinuierliche oder periodische Überwachen des jeweiligen Zustands einer Mehrzahl der Komponenten der elektrischen Schaltanlage aufweisen sowie, wenn bei dem Überwachen eine Zustandsänderung mindestens einer der Komponenten erfasst worden ist, das kontinuierliche oder periodische Aktualisieren des jeweiligen optischen Zustands des jeweiligen kennzeichnenden Komponentensymbols in dem Schaltplan.

Dabei kann das Verfahren das Hinterlegen des aktualisierten Schaltplans nach einer erfolgten Zustandsänderung mindestens einer Komponente der elektrischen Schaltanlage in einem nichtflüchtigen Schreib-Lese-Speicher aufweisen, der in oder an dem mindestens einen Schaltschrankgehäuse mit der elektrischen Schaltanlage, insbesondere an einer an der Innenseite einer Tür des Schaltschrankgehäuses befestigten Schaltplantasche angeordnet ist.

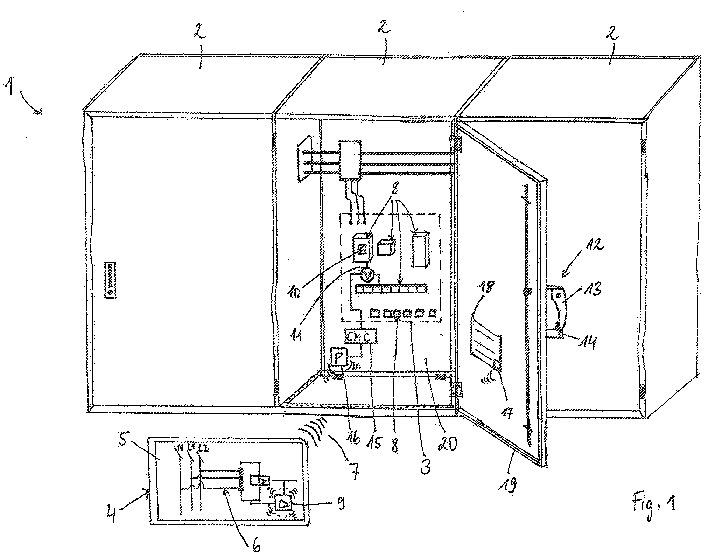

Weitere Einzelheiten der Erfindung werden anhand der nachstehenden Figur 1 erläutert. Diese zeigt schematisch eine beispielhafte Schaltschrankanordnung 1, die aus drei Schaltschrankgehäusen 2 aufgebaut ist. In dem in der Darstellung mittleren Schaltschrankgehäuse 2 ist eine elektrische Schaltanlage aufgenommen, bestehend aus verschiedenen aktiven und passiven Komponenten 8, welche jeweils mindestens einen veränderlichen Zustand aufweisen. Die Komponenten 8 können beispielsweise Schalter sein, die zwischen einem An-Zustand und einem Aus-Zustand umgeschaltet werden können. Die Komponenten können beipspielsweise eine variable Leistungsaufnahme, eine variable Verlustleistung oder eine variable Temperatur aufweisen. Die veränderlichen Zustände der Komponenten 8 der elektrischen Schaltanlage 3 sind auf keine bestimmten Zustände beschränkt, solange diese physikalisch messbar sind.

Eine Mensch-Maschine-Schnittstelle 4 ist als ein Tablet ausgebildet, das an seiner Vorderseite eine optische Anzeige 5 in Form eines Displays aufweist. Auf der optischen Anzeige 5 ist ein Schaltplan 6 der elektrischen Schaltanlage 3 angezeigt. Der aktuelle Schaltplan 6 kann dezentral oder lokal gespeichert sein. Beispielsweise kann die Mensch-Maschine-Schnittstelle 4 einen Speicher aufweisen, in dem der Schaltplan 6 gespeichert ist. Weiterhin kann die elektrische Schaltanlage 3 selbst oder das Schaltschrankgehäuse 2 einen Speicher aufweisen, in dem der Schaltplan hinterlegt ist. Der Schaltplan kann auch in einer Datencloud hinterlegt sein. Im vorliegenden Fall ist vorgesehen, dass zumindest eine an der Innenseite der Schaltschranktür 19 angeordnete Schaltplantasche 18 einen Speicher 17 aufweist, der als Schreib-/Lesespeicher ausgebildet ist. Auf diesem kann der jeweils aktuelle Schaltplan 6 hinterlegt sein.

Zumindest eine der Komponenten 8 der elektrischen Schaltanlage 3 weist eine maschinenlesbare Kennung 10, beispielsweise einen QR-Code, auf. Wenn die Mensch-Maschine-Schnittstelle 4 wie im vorliegenden Fall ein Tablet ist, kann dieses beispielsweise ein Kameramodul aufweisen, mit dem der QR-Code 10 auslesbar ist. Eine Schaltschranküberwachungseinrichtung 15 ist als ein CMC-Modul ausgebildet, welches Zustandsdaten der verschiedenen Komponenten 8 der elektrischen Schaltanlage 3 sammelt und über einen Prozessor 16, der ein optionales Funkmodul aufweist, zur Verfügung stellt. Die Schaltschranküberwachungseinrichtung 15 steht für die Erfassung der Zustandsdaten mit verschiedenen Sensoren 11 kommunikativ in Verbindung, welche die Zustandsdaten der verschiedenen Komponenten 8 erfassen und der Überwachungseinrichtung 15 zur Verfügung stellen.

Nachdem über die optische Anzeige 5 der Mensch-Maschine-Schnittstelle 4 der jeweils die elektrische Schaltanlage 3 betreffende Schaltplan 6 angezeigt worden ist, beispielsweise indem die Mensch-Maschine-Schnittstelle 4 auf den Speicher 17 in der Schaltplantasche 18 zugreift, kann mit Hilfe der Mensch-Maschine-Schnittstelle 4 die maschinenlesbare Kennung 10 einer bestimmten Komponente 8 ausgelesen werden. Daraufhin ist vorgesehen, dass auf der optischen Anzeige 5 das die betreffende Komponente 8 kennzeichnende Komponentensymbol 9 in dem Schaltplan 6 auf der Anzeige 5 optisch hervorgehoben wird. Alternativ oder zusätzlich kann vorgesehen werden, dass ein die Komponente 8 betreffender Messwert gezeigt wird. Dazu kann die Mensch-Maschine-Schnittstelle 4 über die Schnittstelle des Prozessors 16 auf die Überwachungseinrichtung 15 zugreifen, in welcher ein die betreffende Komponente 8 mit der ausgelesenen Kennung 10 kennzeichnender Messwert hinterlegt ist.

Erfindungsgemäß sind jedoch auch Ausführungsformen denkbar, welche auf die Anzeige von Messdaten in dem Schaltplan verzichten. Demgemäß ist bei solchen Ausführungsformen die Verwendung einer Überwachungseinrichtung 15 bzw. die Auslesung einer solchen Überwachungseinrichtung nicht erforderlich. Im einfachsten Fall der Erfindung weist die Schaltschrankanordnung 1 beispielsweise lediglich einen Speicher 17 auf, in dem ein digitaler Schaltplan der elektrischen Schaltanlage 3 hinterlegt ist, die sich in dem betreffenden Schaltschrankgehäuse 2 befindet. Nach dem Einlesen einer maschinenlesbaren Kennung 10 einer der Komponenten 8 kann das die Komponente 8 kennzeichnende Komponentensymbol 9 in dem Schaltplan 6 auf der optischen Anzeige 5 optisch hervorgehoben werden, so dass beispielsweise ein Servicetechniker schnell Aufschluss darüber bekommt, wie die ausgelesene Komponente 8 in der elektrischen Schaltanlage 3 verschaltet ist. Wird die elektrische Schaltanlage 3 verändert, kann diese Veränderung in dem digitalen Schaltplan 6 entsprechend aufgenommen und der Schaltplan 6 in dem Speicher 17 hinterlegt bzw. aktualisiert werden, so dass ein jeweils aktueller Schaltplan 6 vorhanden ist.

Des Weiteren kann vorgesehen sein, dass die Schaltschranktür 19 ein Türschloss 12 mit einem Betätigungsglied 13 aufweist, das über einen elektromechanisch ansteuerbaren Schlossriegel 14 verriegelbar und freigebbar ist. Dazu kann beispielsweise das Türschloss 12 die maschinenlesbare Kennung 10 aufweisen, so dass nach erfolgtem Einlesen der Kennung 10 des Türschlosses 12 und ggf. nach erfolgter Autorisierung über die Mensch-Maschine-Schnittstelle 4 über die Mensch-Maschine-Schnittstelle 4 der Schlossriegel 14 betätigt werden kann.

Darüber hinaus ist es möglich, über die Mensch-Maschine-Schnittstelle 4 Sollwerte für einzelne der Komponenten 8 vorzugeben. Dazu kann beispielsweise in der bereits beschriebenen Weise die Kennung 10 der betreffenden Komponente 8 über die Mensch-Maschine-Schnittstelle 4 eingelesen werden und, nachdem auf dem Schaltplan 6 auf der Anzeige 5 der Schnittstelle 4 das die betreffende Komponente 8 kennzeichnende Komponentensymbol 9 für den Benutzer kenntlich gemacht wurde, durch Manipulation des Symbols 9 ein neuer Sollwert für die Komponente 8 vorgeben werden. Die Manipulation kann beispielsweise darin bestehen, dass ein dem Symbol 9 beigeordneter oder dem Symbol 9 hinterlegter Wert, beispielsweise eine Leistungsaufnahme, über eine Eingabe der Mensch-Maschine-Schnittstelle 4, beispielsweise eine berührungssensitive Eingabe eines Tablets, variiert wird. Über die Datenschnittstelle 7 zwischen der Mensch-Maschine-Schnittstelle 4 und der elektrischen Schaltanlage 8, ggf. unter Zwischenschaltung eines Prozessors 16 mit einer Datenschnittstelle sowie einer Überwachungseinrichtung 15, die auch als Steuereinrichtung dienen kann, wird der manipulierte Sollwert für den Zustand der betreffenden Komponente 8 an die Komponente 8 der elektrischen Schaltanlage 3 weitergeleitet, bzw. ein dem Sollwert entsprechendes Ansteuersignal an die betreffende Komponente 8 weitergeleitet werden, so dass sie im Folgenden ihren Zustand auf den Sollwert ändert.

### Bezugszeichenliste:

- 1: Schaltschrankanordnung
- 2: Schaltschrankgehäuse
- 3: Elektrische Schaltanlage
- 4: Mensch-Maschine-Schnittstelle
- 5: Optische Anzeige
- 6: Schaltplan
- 7: Datenschnittstelle
- 8: Komponente
- 9: Komponentensymbol
- 10: Maschinenlesbare Kennung
- 11: Sensoranordnung
- 12: Türschloss
- 13: Betätigungsglied
- 14: Schlossriegel
- 15: Überwachungseinrichtung
- 16: Prozessor
- 17: Speicher
- 18: Schaltplantasche
- 19: Tür
- 20: Montageplatte

## Patentansprüche

1. Schaltschrankanordnung (1), die mindestens ein Schaltschrankgehäuse (2) mit einer elektrischen Schaltanlage (3) und weiterhin eine Mensch-Maschine-Schnittstelle (4) mit einer optischen Anzeige (5) aufweist, über die ein Schaltplan (6) der elektrischen Schaltanlage (3) angezeigt ist, wobei mindestens eine Komponente (8) der elektrischen Schaltanlage (3) eine maschinenlesbare Kennung (10) aufweist, über die die Komponente (8) einem diese kennzeichnenden Komponentensymbol (9) in dem Schaltplan (6) eindeutig zugeordnet ist, wobei eine Datenschnittstelle (7) zwischen der Mensch-Maschine-Schnittstelle (4) und der elektrischen Schaltanlage (3) ausgebildet und ein Zustand der Komponente (8) anhand eines optischen Zustands des Komponentensymbols (9) über die optische Anzeige (5) angezeigt ist, und wobei die Mensch-Maschine-Schnittstelle (4) dazu eingerichtet ist, eine Änderung der elektrischen Schaltanlage (3), insbesondere die Hinzufügung oder Entfernung einer elektrischen Komponente (8), zu erfassen und diese Änderung in den Schaltplan (6) zu übernehmen, **dadurch gekennzeichnet, dass** die Mensch-Maschine-Schnittstelle (4) eine optische Erfassungseinrichtung aufweist, etwa ein Photomodul, die eine Komponentenerkennung aufweist, wobei die Komponentenerkennung dazu eingerichtet ist, die maschinenlesbare Kennung (10) der Komponenten (8) der elektrischen Schaltanlage (3) zu erfassen und durch Abgleich mit dem Schaltplan (6) eine Veränderung einer Komponentenbestückung der elektrischen Schaltanlage (3) zu erfassen.

2. Schaltschrankanordnung (1) nach Anspruch 1, bei der die Mensch-Maschine-Schnittstelle (4) eine bidirektionale Schnittstelle ist, über die mindestens ein Istwert des Zustands der Komponente (8), beispielsweise ein sensorisch erfasster Messwert, an die Mensch-Maschine-Schnittstelle (4) weitergeleitet und gegebenenfalls über die optische Anzeige (5) angezeigt ist und/oder ein über eine Eingabe der Mensch-Maschine-Schnittstelle (4) erfasster Sollwert des Zustands der Komponente (8) an die Komponente (8) oder eine die Komponente (8) ansteuernde Steuereinheit im Innern weitergeleitet ist.

3. Schaltschrankanordnung (1) nach Anspruch 1 oder 2, bei der der optische Zustand des Komponentensymbols (9) über die Mensch-Maschine-Schnittstelle (4) manipulierbar ist, wobei entsprechend einer erfolgten Manipulation des Zustands des Komponentensymbols (9) ein Zustandsänderungssignal erzeugt und an die Komponente (8) oder eine die Komponente (8) ansteuernde Steuereinheit weitergeleitet ist.

4. Schaltschrankanordnung (1) nach einem der vorangegangen Ansprüche, bei der die elektrische Schaltanlage (3) im Innern des mindestens einen Schaltschrankgehäuses (2) aufgenommen ist, wobei eine Sensoranordnung (11) mit mindestens einem Sensor dazu eingerichtet ist, mindestens einen Messwert der mindestens einen elektronischen Komponente (8) der elektrischen Schaltanlage (3) zu erfassen, wobei der Messwert oder eine davon abgeleitete optische Ausgabe auf der optischen Anzeige (5) örtlich dem die Komponente (8) kennzeichnenden Komponentensymbol (9)zugeordnet ausgegeben ist.

5. Schaltschrankanordnung (1) nach einem der vorangegangen Ansprüche, bei der die elektrische Schaltanlage (3) eine Komponente (8) mit einer diese Komponente (8) eindeutig identifizierenden maschinenlesbaren Kennung (10) aufweist, wobei die Mensch-Maschine-Schnittstelle (4) dazu eingerichtet ist, nach erfolgtem Auslesen der Kennung (10) und Identifizieren der von der Kennung (10) gekennzeichneten Komponente (8), das die Komponente (8) repräsentierende Komponentensymbol (9) in dem optisch angezeigten Schaltplan (6) optisch hervorzuheben und/oder mindestens einen die Komponente (8) betreffenden Mess- oder Kennwert über die optische Anzeige (5) auszugeben.

6. Schaltschrankanordnung (1) nach einem der vorangegangen Ansprüche, bei der die Komponente (8) ein Türschloss (12) des Schaltschrankgehäuses (2) ist, das ein Betätigungsglied (13) zur Verstellung des Türschlosses (12) zwischen einer Offenposition und einer Schließposition aufweist, wobei das Türschloss (12) einen elektronisch ansteuerbaren Schlossriegel (14) aufweist, der in seinem ersten Zustand eine Verriegelungsposition einnimmt, in der er das Betätigungsglied (13) in der Schließposition verriegelt, und der in seinem zweiten Zustand eine Freigabeposition einnimmt, in der er das Betätigungsglied (13) freigibt.

7. Schaltschrankanordnung (1) nach einem der vorangegangen Ansprüche, bei der die Komponente (8) eine Power Distribution Unit (PDU) ist, über die mindestens eine weitere elektrische Komponente (8) der elektrischen Schaltanlage (3) mit elektrischer Energie versorgt ist, und mit der der mindestens eine die weitere Komponente (8) betreffende Zustand, insbesondere eine Messgröße, erfasst und über die Datenschnittstelle (7) an die Mensch-Maschine-Schnittstelle (4) weitergeleitet ist.

8. Schaltschrankanordnung (1) nach einem der vorangegangen Ansprüche, die eine Überwachungseinrichtung (15) aufweist, die dazu eingerichtet ist, den jeweiligen Zustand einer Mehrzahl der Komponenten (8) der elektrischen Schaltanlage (3) zu überwachen und, wenn eine Zustandsänderung mindestens einer der Komponenten (8) erfasst ist, den optischen Zustand des jeweiligen kennzeichnenden Komponentensymbols (9) in dem Schaltplan (6) zu aktualisieren, so dass ein aktualisierter Schaltplan (6) erzeugt ist.

9. Schaltschrankanordnung (1) nach Anspruch 8, die weiterhin einen Prozessor (16) mit Schreib-Lese-Zugriff auf einen nichtflüchtigen Speicher (17) aufweist, wobei der Speicher (17) in oder an dem mindestens einen Schaltschrankgehäuse (2) mit der elektrischen Schaltanlage (3), insbesondere an einer an der Innenseite einer Tür (19) des Schaltschrankgehäuses (2) befestigten Schaltplantasche (18) angeordnet ist, wobei der Prozessor (16) dazu eingerichtet ist, den aktualisierten Schaltplan (6) in den nichtflüchtigen Schreib-Lese-Speicher (17) zu schreiben.

10. Betriebsverfahren für eine Schaltschrankanordnung (1) nach einem der vorangegangen Ansprüche, das die Schritte aufweist:
- Auswählen einer bestimmten elektrischen Komponente (8) aus einer Mehrzahl elektrischer Komponenten (8) der elektrischen Schaltanlage (3) der Schaltschrankanordnung (1) durch Einlesen der Kennung (10) der bestimmten Komponente (8);
- Anzeigen des Schaltplans (6) auf einer optischen Anzeige (5) der Mensch-Maschine-Schnittstelle (4), wobei ein Zustand der Komponente (8) anhand eines optischen Zustands des die bestimmte Komponente (8) kennzeichnenden Komponentensymbols (9) über die optische Anzeige (5) angezeigt wird;
- Erfassen einer Änderung der elektrischen Schaltanlage (3) mit einer Komponentenerkennung einer optischen Erfassungseinrichtung der Mensch-Maschine-Schnittstelle (4), insbesondere die Hinzufügung oder Entfernung einer elektrischen Komponente (8) und Übernehmen dieser Änderung in den Schaltplan (6), wobei die Komponentenerkennung die maschinenlesbare Kennung (10) der Komponenten (8) der elektrischen Schaltanlage (3) erfasst und durch Abgleichen mit dem Schaltplan (6) eine Veränderung einer Komponentenbestückung der elektrischen Schaltanlage (3) erfasst.

11. Betriebsverfahren nach Anspruch 10, bei dem das Anzeigen das Abrufen des Zustands der bestimmten Komponente (8) unmittelbar von der bestimmten Komponente (8) oder von einer Überwachungseinrichtung (15) umfassen, in der aktuelle und/oder historische Zustandsdaten zumindest betreffend die bestimmte Komponente (8) vorgehalten sind.

12. Betriebsverfahren nach Anspruch 10 oder 11, bei dem für eine Änderung des Zustands der bestimmten Komponente (8) Zustandsänderungsdaten oder Zustandsänderungsbefehle über die Mensch-Maschine-Schnittstelle (4) eingegeben und über die Datenschnittstelle (7) an die bestimmte Komponente (8) unmittelbar oder mittelbar über eine diese ansteuernde Steuereinheit, die Teil der elektrischen Schaltanlage (3) ist, weitergeleitet werden.

13. Betriebsverfahren nach einem der Ansprüche 10 bis 12, bei dem die bestimmte Komponente (8) ein Türschloss (12) mit einem elektronisch ansteuerbaren Schlossrigel (14) ist, der in seinem ersten Zustand eine Verriegelungsposition einnimmt, in der er ein Betätigungsglied (13) verriegelt, und der in seinem zweiten Zustand eine Freigabeposition einnimmt, in der er das Betätigungsglied (13) freigibt, wobei das Verfahren weiterhin das Eingeben eines Freigabebefehls oder eines Verriegelungsbefehls über die Mensch-Maschine-Schnittstelle (4) aufweist, woraufhin der Schlossriegel entsprechend dem Befehl in die Freigabeposition oder die Verriegelungsposition überführt wird.

14. Betriebsverfahren nach einem der Ansprüche 10 bis 13, das das Ändern des Zustands der bestimmten Komponente (8) und das Hinterlegen des geänderten Zustands durch Ändern des optischen Zustands des kennzeichnenden Komponentensymbols (9) in dem Schaltplan (6) aufweist.

15. Betriebsverfahren nach einem der Ansprüche 10 bis 14, das das kontinuierliche oder periodische Überwachen des jeweiligen Zustands einer Mehrzahl der Komponenten (8) der elektrischen Schaltanlage (3) und, wenn bei dem Überwachen eine Zustandsänderung mindestens einer der Komponenten (8) erfasst worden ist, das kontinuierliche oder periodische Aktualisieren des jeweiligen optischen Zustands des jeweiligen kennzeichnenden Komponentensymbols (9) in dem Schaltplan (6) aufweist.

16. Betriebsverfahren nach Anspruch 15, das das Hinterlegen des aktualisierten Schaltplans (6) nach einer erfolgten Zustandsänderung mindestens einer Komponente (8) der elektrischen Schaltanlage (3) in einem nichtflüchtigen Schreib-Lese-Speicher aufweist, der in oder an dem mindestens einen Schaltschrankgehäuse (2) mit der elektrischen Schaltanlage (3), insbesondere an einer an der Innenseite einer Tür (19) des Schaltschrankgehäuses (2) befestigten Schaltplantasche (18) angeordnet ist.

## Claims

1. Switch cabinet arrangement (1), which comprises at least one switch cabinet housing (2) with an electrical switchgear (3) and further a human-machine-interface (4) with an optical display (5), via which a circuit diagram (6) of the electrical switchgear (3) is displayed, wherein at least one component (8) of the electrical switchgear (3) comprises a machine-readable identifier (10), via which the component (8) is uniquely assigned to a component symbol (9) in the circuit diagram (6) indicating the component, wherein a data interface (7) is formed between the human-machine-interface (4) and the electrical switchgear (3) and a state of the component (8) is displayed by means of an optical state of the component symbol (9) via the optical display (5), and wherein the human-machine-interface (4) is configured to detect a change of the electrical switchgear (3), in particular addition or removal of an electrical component (8), and to adopt this change in the circuit diagram (6), **characterized in that** the human-machine-interface (4) comprises an optical detection unit, such as a photo module, which comprises a component detection, wherein the component detection is configured to detect the machine-readable identifier (10) of the component (8) of the electrical switchgear (3) and to detect a change of a component population of the electrical switchgear (3) by comparing with the circuit diagram (6).

2. The switch cabinet arrangement (1) according to claim 1, in which the human-machine-interface (4) is a bidirectional interface, via which at least an actual value of the state of the component (8), e.g. a sensorially detected measured value, is passed to the human-machine-interface (4) and optionally displayed by the optical display (5) and/or a setpoint detected via an input of the human-machine-interface (4) of the state of the component (8) is passed to the component (8) or a control unit controlling the component (8) in the interior.

3. The switch cabinet arrangement (1) according to claim 1 or 2, in which the optical state of the component symbol (9) is manipulatable via the human-machine-interface (4), wherein a state change signal is generated corresponding to a manipulation of the state of the component symbol (9) and passed to the component (8) or a control unit controlling the component (8).

4. The switch cabinet arrangement (1) according to any of the preceding claims, in which the electrical switchgear (3) is accommodated in the interior of the at least one switch cabinet housing (2), wherein a sensor arrangement having at least one sensor is configured to detect at least one measured value of the electrical component (8) of the electrical switchgear (3), wherein the measured value or an optical output derived therefrom is displayed on the optical display (5) locally assigned to the component symbol (9) indicating the component (8).

5. The switch cabinet arrangement (1) according to any of the preceding claims, in which the electrical switchgear (3) comprises a component (8) having a machine-readable identifier (10) uniquely identifying the component (8), wherein the human-machine-interface (4) is configured to, after reading the identifier (10) and identifying the component (8) identified by the identifier (10), optically highlight the component symbol (9) representing the component (8) in the optically displayed circuit diagram (6) and/or display at least one measured value or characteristic value related to the component (8) via the optical display (5).

6. The switch cabinet arrangement (1) according to any of the preceding claims, in which the component (8) is a door lock (12) of the switch cabinet housing (2), which door lock has an actuating element (13) for adjusting the door lock (12) between an open position and a closed position, wherein the door lock (12) has an electronically controllable lock bolt (14), which assumes in its first state a locking position, in which it locks the actuating element (13) in the closed position, and which assumes in its second state a release position, in which it releases the actuating element (13).

7. The switch cabinet arrangement (1) according to any of the preceding claims, in which the component (8) is a power distribution unit (PDU), with which the at least one further electrical component (8) of the electrical switchgear (3) is supplied with electric power, and with which the at least one state relating to the further component (8), in particular a measured value, is detected and passed to the human-machine-interface (4) via the data interface (7).

8. The switch cabinet arrangement (1) according to any of the preceding claims, which comprises a monitoring device (15), which is configured to monitor the respective state of a multitude of components (8) of the electrical switchgear (3) and, when a change of state of at least one of the components (8) is detected, to update the optical state of the respective indicating component symbol (9) in the circuit diagram (6), so that an updated circuit diagram (6) is generated.

9. The switch cabinet arrangement (1) according to claim 8, which further comprises a processor (16) with read-write access to a non-volatile memory (17), wherein the memory (17) is arranged in or on the at least one switch cabinet housing (2) having the electrical switchgear (3), in particular on a circuit diagram pocket (18) fastened to the inner side of a door (19) of the switch cabinet housing (2), wherein the processor (16) is configured to write the updated circuit diagram (6) to the non-volatile write-read memory (17).

10. Operating method for a switch cabinet arrangement (1) according to any of the preceding claims, comprising the steps:
- selecting a specific electrical component (8) of a multitude of electrical components (8) of the electrical switchgear (3) of the switch cabinet arrangement (1) by reading the identifier (10) of the specific component (8);
- displaying the circuit diagram (6) on an optical display (5) of the human-machine-interface (4), wherein a state of the component (8) is displayed via the optical display (5) by means of an optical state of the component symbol (9) indicating the specific component (8);
- detecting a change of the electrical switchgear (3) with a component detection of an optical detection unit of the human-machine-interface (4), in particular adding or removal of an electrical component (8) and adopting this change in the circuit diagram (6), wherein the component detection detects the machine-readable identifier (10) of the component (8) of the electrical switchgear (3) and detects a change of the component population of the electrical switchgear (3) by comparing with the circuit diagram (6).

11. The operating method according to claim 10, in which the displaying comprises the retrieving of the state of the particular component (8) directly from the specific component (8) or from a monitoring device (15), in which the current and/or historical state data at least related to the specific component (8) is stored.

12. The operating method according to claim 10 or 11, in which for a change of the state of the specific component (8) state change data or state change commands are inputted via the human-machine-interface (4) and passed to the specific component (8) directly via the data interface (7) or indirectly via a control unit controlling said component, which control unit is part of the electrical switchgear (3).

13. The operating method according to any of claims 10 to 12, in which the specific component (8) is a door lock (12) having an electronically controllable lock bolt (14), which assumes in its first state a locking position, in which it locks an actuating element (13), and which assumes in its second state a release position, in which it releases the actuating element (13), wherein the method further comprises the inputting of a release command or a locking command via the human-machine-interface (4), whereupon the lock bolt is transferred in the release position or in the locking position according to the command.

14. The operating method according to any of claims 10 to 13, which comprises the changing of the state of the specific component (8) and the storing of the changed state by changing the optical state of the indicating component symbols (9) in the circuit diagram (6).

15. The operating method according to any of claims 10 to 14, which comprises the continuous or periodic monitoring of the respective state of a multitude of the components (8) of the electrical switchgear (3) and, when a state change of at least one of the components (8) has been detected when monitoring, the continuous or periodic updating of the respective optical state of the respective indicating component symbol (9) in the circuit diagram (6).

16. The operating method according to claim 15, which comprises the storing of the updated circuit diagram (6) after a change of state of at least one component (8) of the electrical switchgear (3) has occurred in a non-volatile write-read memory, which is arranged in or on at least one of the switch cabinet housings (2) having the electrical switchgear (3), in particular on a circuit diagram pocket (18) fastened to the inner side of a door (19) of the switch cabinet housing (2).

## Revendications

1. Disposition d'armoire de commande (1), qui comprend un boîtier d'armoire de commande (2) avec une installation électrique (3) et en outre une interface home-machine (4) avec un affichage optique (5), par l'intermédiaire de laquelle un schéma de branchement (6) de l'installation électrique (3) est affiché, au moins un composant (8) de l'installation électrique (3) comprenant un identifiant lisible par une machine (10), par l'intermédiaire duquel un symbole de composant (9) caractérisant le composant (8) est attribué à celui-ci dans le schéma de branchement (6), une interface de données (7) étant disposée entre l'interface homme-machine (4) et l'installation électrique (3) et un état du composant (8) étant affiché à l'aide d'un état optique du symbole de composant (9) par l'intermédiaire de l'affichage optique (5) et l'interface homme-machine (4) étant conçue pour détecter une modification de l'installation électrique (3), plus particulièrement l'ajout ou le retrait d'un composant électrique (8) et pour prendre en compte cette modification dans le schéma de branchement (6), **caractérisée en ce que** l'interface homme-machine (4) comprend un dispositif de détection optique, par exemple un module photo-électrique, qui comprend une reconnaissance de composant, la reconnaissance de composant étant conçue pour détecter l'identifiant lisible par une machine (10) du composant (8) de l'installation électrique (3) et de détecter, par comparaison avec le schéma de branchement (6), une modification d'un équipement en composants de l'installation électrique (3).

2. Disposition d'armoire de commande (1) selon la revendication 1, dans laquelle l'interface homme-machine (4) est une interface bidirectionnelle par l'intermédiaire de laquelle au moins une valeur réelle de l'état du composant (8), par exemple une valeur de mesure mesurée par des capteurs, est transmise à l'interface homme-machine (4) et, le cas échéant, affichée par l'intermédiaire de l'affichage optique (5) et/ou une valeur de consigne de l'état du composant (8) est transmise par l'intermédiaire d'une entrée de l'interface homme-machine (4) au composant (8) ou à une unité de commande à l'intérieur contrôlant la composant (8).

3. Disposition d'armoire de commande (1) selon la revendication 1 ou 2, dans laquelle l'état optique du symbole de composant (9) peut être manipulé par l'intermédiaire de l'interface homme-machine (4), un signal de modification d'état étant généré en fonction d'une manipulation de l'état du symbole de composant (9) et transmis au composant (8) ou à une unité de commande contrôlant la composant (8).

4. Disposition d'armoire de commande (1) selon l'une des revendications précédentes, dans laquelle l'installation électrique (3) est logée à l'intérieur de l'au moins un boîtier d'armoire de commande (2), une disposition de capteurs (11) avec au moins un capteur étant conçue pour mesurer au moins une valeur de mesure de l'au moins un composant électronique (8) de l'installation électrique (3), la valeur de mesure ou une sortie optique dérivée de celle-ci étant générée localement sur l'affichage optique (5), en correspondance avec le symbole de composant (9) identifiant le composant (8).

5. Disposition d'armoire de commande (1) selon l'une des revendications précédentes, dans laquelle l'installation électrique (3) comprend un composant (8) avec un identifiant lisible par une machine (10) identifiant de manière unique ce composant (8), l'interface homme-machine (4) étant conçue pour souligner optiquement, après la lecture de l'identifiant (10) et l'identification du composant (8) **caractérisé par** l'identifiant (10), le symbole de composant (9) représentant le composant (8) dans le schéma de branchement (6) affiché optiquement et/ou pour sortir au moins une valeur de mesure ou d'identification concernant le composant (8) par l'intermédiaire de l'affichage optique (5).

6. Disposition d'armoire de commande (1) selon l'une des revendications précédentes, dans laquelle le composant (8) est une serrure de porte (12) du boîtier d'armoire de commande (2), qui comprend un organe d'actionnement (13) pour le déplacement de la serrure de porte (12) entre une position ouverte et une position fermée, la serrure de porte (12) comprenant un verrou de serrure (14) contrôlable électroniquement qui, dans son premier état, adopte une position de verrouillage dans laquelle il verrouille l'organe d'actionnement (13) dans la position fermée et qui, dans son deuxième état, adopte une position de libération dans laquelle il libère l'organe d'actionnement (13).

7. Disposition d'armoire de commande (1) selon l'une des revendications précédentes, dans laquelle le composant (8) est une Power Distribution Unit (PDU) par l'intermédiaire de laquelle au moins un autre composant électrique (8) de l'installation électrique (3) est alimentée en énergie électrique et avec laquelle l'au au moins un état concernant l'autre composant (8), plus particulièrement une grandeur de mesure, est mesuré et est transmis par l'intermédiaire de l'interface de données (7) à l'interface homme-machine (4).

8. Disposition d'armoire de commande (1) selon l'une des revendications précédentes, qui comprend un dispositif de surveillance (15) qui est conçu pour surveiller l'état respectif d'une pluralité de composants (8) de l'installation électrique (3) et, lorsqu'une modification d'état d'au moins un des composants (8) est détectée, pour actualiser l'état optique du symbole de composant (9) qui l'identifie dans le schéma de branchement (6), de façon à générer un schéma de branchement (6) actualisé.

9. Disposition d'armoire de commande (1) selon la revendication 8, qui comprend en outre un processeur (16) avec un accès en lecture et en écriture à une mémoire non volatile (17), la mémoire (17) étant disposée dans ou sur l'au moins un boîtier d'armoire de commande (2) avec l'installation électrique (3), plus particulièrement sur une poche pour schéma de branchement (18) fixée sur le côté intérieur d'une porte (19) du boîtier d'armoire de commande (2), le processeur (16) étant conçu pour écrire le schéma de branchement (6) actualisé dans la mémoire vive non volatile (17).

10. Procédé d'exploitation pour une disposition d'armoire de commande (1) selon l'une des revendications précédentes, qui comprend les étapes suivantes :
- sélection d'un composant électrique (8) déterminé parmi une pluralité de composants électriques (8) de l'installation électrique (3) de la disposition d'armoire de commande (1) par lecture de l'identifiant (10) du composant (8) déterminé ;
- affichage du schéma de branchement (6) sur un affichage optique (5) de l'interface homme-machine (4), un état du composant (8) étant affiché à l'aide d'un état optique du symbole de composant (9) caractérisant le composant (8) déterminé par l'intermédiaire de l'affichage optique (5) ;
- détection d'une modification de l'installation électrique (3) avec une reconnaissance de composants d'un dispositif de détection optique de l'interface homme-machine (4), plus particulièrement l'ajout ou le retrait d'un composant électrique (8) et prise en compte de cette modification dans le schéma de branchement (6), la reconnaissance de composant détectant l'identifiant lisible par une machine (10) du composant (8) de l'installation électrique (3) et détectant, par comparaison avec le schéma de branchement (6), une modification d'un équipement en composants de l'installation électrique (3).

11. Procédé d'exploitation selon la revendication 10, dans lequel l'affichage comprend l'interrogation de l'état du composant (8) déterminé directement par le composant (8) déterminé ou par un dispositif de surveillance (15), dans lequel sont enregistrés des données d'état actuelles et/ou historiques concernant au moins le composant (8) déterminé.

12. Procédé d'exploitation selon la revendication 10 ou 11, dans lequel, pour une modification de l'état du composant (8) déterminé, des données de modification d'état ou des instructions de modification d'état sont entrées par l'intermédiaire de l'interface homme-machine (4) et sont transmises par l'intermédiaire de l'interface de donnée (7) au composant (8) déterminé directement ou indirectement par l'intermédiaire de l'unité de commande contrôlant celui-ci, qui fait partie de l'installation électrique (3).

13. Procédé d'exploitation selon l'une des revendications 10 à 12, dans lequel le composant (8) déterminé est une serrure de porte (12) avec un verrou de serrure (14) contrôlable électroniquement qui, dans son premier état, adopte une position de verrouillage dans laquelle il verrouille un organe d'actionnement (13) et qui, dans son deuxième état, adopte une position de libération dans laquelle il libère l'organe d'actionnement (13), ce procédé comprenant en outre l'entrée d'une instruction de libération ou d'une instruction de verrouillage par l'intermédiaire de l'interface homme-machine (4), ce qui permet mettre le verrou de serrure, en fonction de l'instruction, dans la position de libération ou dans la position de verrouillage.

14. Procédé d'exploitation selon l'une des revendications 10 à 13, qui comprend la modification de l'état du composant (8) déterminé et l'enregistrement de l'état modifié par la modification de l'état optique du symbole de composant (9) dans le schéma électrique (6).

15. Procédé d'exploitation selon l'une des revendications 10 à 14, qui comprend la surveillance continuelle ou périodique de l'état respectif d'une pluralité de composants (8) de l'installation électrique (3) et, lorsque, lors de la surveillance, une modification d'état d'au moins un des composants (8) est détectée, l'actualisation continuelle ou périodique de l'état optique respectif du symbole de composant (9) respectif dans le schéma électriques (6).

16. Procédé d'exploitation selon la revendication 15, qui comprend l'enregistrement du schéma de branchement (6) selon la modification d'état d'au moins un composant (8) de l'installation électrique (3) dans une mémoire vive non volatile, qui est disposée dans ou sur un boîtier d'armoire de commande (2) avec l'installation électrique (3), plus particulièrement sur une poche de schéma électrique (18) fixée sur le côté intérieur d'une porte (19) du boîtier d'armoire de commande (2).
